# EUROPÄISCHE PATENTSCHRIFT

(11) **EP 1 645 013 B1**
(45) Veröffentlichungstag und Bekanntmachung des Hinweises auf die Patenterteilung: **21.01.2009**
(21) Anmeldenummer: 04740752.3
(22) Anmeldetag: 07.07.2004
(51) Int. Cl.: H01R 12/20, H05K 3/34

(54) **BAUTEIL FÜR EINE LEITERPLATTE**
COMPONENT FOR A PRINTED CIRCUIT BOARD
COMPOSANT DESTINE A UNE PLAQUETTE

(30) Priorität: 14.07.2003 DE 10331840
(43) Veröffentlichungstag der Anmeldung: 12.04.2006
(73) Patentinhaber: Rosenberger Hochfrequenztechnik GmbH & Co., 84529 Tittmoning (DE)
(72) Erfinder: BLAKBORN, Willem, 83334 Inzell (DE)
(74) Vertreter: Zeitler, Giselher
(86) Internationale Anmeldenummer: PCT/EP2004/007440
(87) Internationale Veröffentlichungsnummer: WO 2005/006821

(56) Entgegenhaltungen:
- EP-A- 0 872 919
- WO-A-20/05006501
- DE-A1- 4 132 996
- GB-A- 2 259 613
- US-A- 4 541 034
- US-A- 5 295 862
- US-A- 6 159 045
- US-B1- 6 179 631
- PATENT ABSTRACTS OF JAPAN Bd. 015, Nr. 280 (E-1090), 16. Juli 1991 (1991-07-16) -& JP 03 095962 A (IBIDEN CO LTD), 22. April 1991 (1991-04-22)
- PATENT ABSTRACTS OF JAPAN Bd. 1997, Nr. 12, 25. Dezember 1997 (1997-12-25) & JP 09 219581 A (FUJITSU TEN LTD), 19. August 1997 (1997-08-19)

## Beschreibung

Die vorliegende Erfindung betrifft ein Bauteil für eine Leiterplatte, gemäß dem Oberbegriff des Anspruchs 1.

Beim Bestücken eine Leiterplatte mit Bauteilen ist es für manche Bauteile notwendig, diese zusätzlich durch einen Zapfen mit Verrastung mechanisch an der Leiterplatte zu befestigen. Hierbei greift der Zapfen durch ein Loch der Leiterplatte, wobei eine Rastnase an dem durchgreifenden Ende des Zapfens mit der dem Bauteil gegenüberliegenden Seite der Leiterplatte verrastet und dadurch das einmal eingesteckte Bauteil mechanisch fixiert. Hierbei ist es jedoch von Nachteil, dass bereits die Setzkraft 10N beträgt, die von herkömmlichen Bestückungsautomaten nicht aufgebracht werden kann. Dies gilt dann umso mehr für die Kraft zum Einrasten, die üblicherweise 60N bis 110N beträgt. Daher müssen bisher solche Bauteile manuell eingesetzt und verrastet werden. Dies erfordert jedoch einen hohen Aufwand.

Aus der US-A-6 159 045 ist ein Verfahren und eine gattungsgemäße Vorrichtung zum Verbinden eines elektrischen Bauteils mit hakenförmigen Zapfen mit einer Leiterplatte bekannt. Hierbei ist vor dem Lötvorgang eine Innenwandung des Loches in der Leiterplatte mit Lot benetzt.

Der Erfindung liegt die Aufgabe zugrunde, ein Bauteil und ein Verfahren der o.g. Art dahingehend zu verbessern, dass ein Bestücken und Verrasten dieses Bauteils auf einer Leiterplatte maschinell prozesssicher und mit wenig Aufwand ausgeführt werden kann.

Diese Aufgabe wird erfindungsgemäß durch ein Bauteil der o.g. Art mit den in Anspruch 1 gekennzeichneten Merkmalen gelöst. Vorteilhafte Ausgestaltungen der Erfindung sind in den weiteren Ansprüchen beschrieben.

Bei einem Bauteil der o.g. Art ist es erfindungsgemäß vorgesehen, dass der Umfang des Zapfens in Längsrichtung über den gesamten im Loch der Leiterplatte befindlichen Abschnitt mit wenigstens einer Ausnehmung ausgebildet ist, wobei der geringere Durchmesser des Zapfens im Vergleich zum Loch und die Ausnehmungen derart ausgebildet sind, dass zwischen dem Außenumfang des Zapfens und dem Innenumfang des Loches ein Zwischenraum mit für Lot kapillaren Eigenschaften ausgebildet ist.

Dies hat den Vorteil, dass zum Bestücken und Verrasten des Bauteils auf der Leiterplatte keine besonders hohe Kraft notwendig ist, so dass diese Arbeit automatisiert maschinell auf einer Fertigungsstraße für Leiterplatten mit Bestückungsautomat und Heißluftofen durchgeführt werden kann, wobei nach dem Lötvorgang im Heißluftofen automatisch eine Verrastung des Bauteils mit dem in das Loch in der Leiterplatte eingedrungenen Lot hergestellt ist. Gleichzeitig ergibt sich ein toleranzfreier Formschluss zwischen Zapfen und Innenumfang des Loches in der Leiterplatte in einer Ebene der Leiterplatte. Die Bestückung von Bauteilen mit Verrastung kann dadurch sehr kostengünstig bei gleichzeitig hohen Haltekräften und wenig Toleranz erfolgen.

Eine formschlüssige Verbindung ohne Toleranzen in Richtung entlang einer Längsachse des Loches in der Leiterplatte erzielt man dadurch, dass die Rastnase am Zapfen derart angeordnet und ausgebildet ist, dass bei vollständig auf die Leiterplatte aufgesetztem Bauteil die Rastnase innerhalb des Loches in der Leiterplatte angeordnet ist.

Einen besonders guten Formschluss zwischen dem in das Loch in der Leiterplatte eindringenden Lot und der Leiterplatte erzielt man dadurch, dass das Loch in der Leiterplatte metallisiert ist.

Der Zapfen ist beispielsweise aus Kunststoff hergestellt, so dass an diesem keine mechanisch feste Verbindung mit dem Lot entsteht.

Die Erfindung wird im Folgenden anhand der Zeichnung näher erläutert. Diese zeigt in:
- Fig. 1: eine bevorzugte Ausführungsform eines Bauteils aufgesetzt auf eine Leiterplatte in Aufsicht,
- Fig. 2: eine Ansicht von Detail X von Fig. 1 vor einem Lötvorgang,
- Fig. 3: eine Schnittansicht entlang Linie A-A von Fig. 2,
- Fig. 4: eine Ansicht von Detail X von Fig. 1 nach einem Lötvorgang und
- Fig. 5: eine Schnittansicht entlang Linie B-B von Fig. 4.

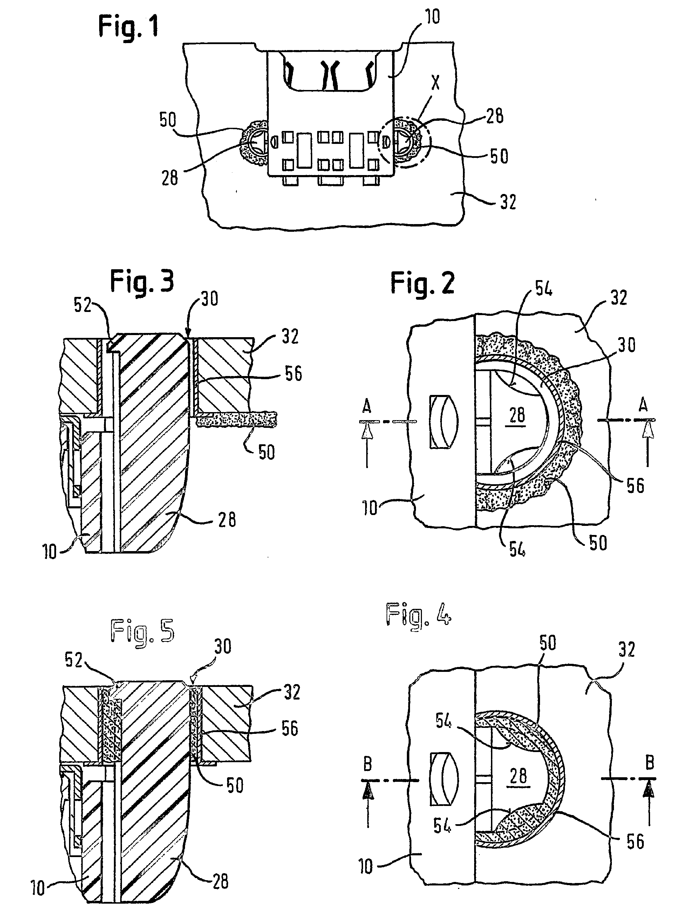

Fig. 1 zeigt eine bevorzugte Ausführungsform eines Bauteils für eine Leiterplatte 32. Das Bauteil umfaßt ein Gehäuse 10, dem zwei Zapfen 28 angeformt sind. In Fig. 1 ist das Bauteil auf die Leiterplatte 32 aufgesetzt, wobei jeder Zapfen 28 in ein metallisiertes Loch 30 in der Leiterplatte 32 greift.

Fig. 2 und 3 veranschaulichen zusätzlich den Zustand des aufgesetzten Bauteils vor einem Lötvorgang, wobei eine Metallisierung 56 des Loches 30 ersichtlich ist. Um einen Teil des Umfanges des Loches 30 ist Lotpaste 50 aufgetragen und der Zapfen 28 ragt in das Loch 30 hinein. Der Zapfen 28 ist an seinem freien Ende mit einer Rastnase 52 ausgebildet, wobei der Durchmesser des Zapfens 28 im Bereich der Rastnase 52 kleiner ist als der Innendurchmesser des Loches 30. Auch im restlichen Abschnitt des Zapfens 28, der in das Loch 30 eingreift, ist der Durchmesser des Zapfens 28 kleiner ausgebildet als der Innendurchmesser des Loches 30. Zusätzlich ist die Länge des Zapfens 28 derart gewählt, daß sich bei vollständig auf die Leiterplatte 32 aufgesetztem Bauteil die Rastnase 52 noch innerhalb des Loches 30 befindet, wie insbesondere aus Fig. 3 ersichtlich. Zusätzlich ist der Zapfen 28 in Längsrichtung mit Ausnehmungen 54 versehen, wie insbesondere aus Fig. 2 ersichtlich. Der geringere Durchmesser des Zapfens 28 im Vergleich zum Loch 30 und die Ausnehmungen 54 sind derart gewählt, daß zwischen dem Außenumfang des Zapfens 28.und dem Innenumfang des Loches 30 ein Zwischenraum mit kapillaren Eigenschaften ausgebildet ist.

In einem Herstellungsverfahren, bei dem zunächst alle Bauteile von einem Bestückungsautomaten auf die Leiterplatte 32 aufgesetzt werden und anschließend ein Lötvorgang in einem Heißluftofen erfolgt, wird das Lot 50 erwärmt und geht in die flüssige Phase über. Das flüssige Lot 50 dringt dann durch die kapillarwirkung sowie zusätzlich unterstützt von einer Adhäsionskraft in den Zwischenraum zwischen dem Außenumfang des Zapfens 28 und dem Innenumfang des Loches 30 ein und füllt diesen im wesentlichen vollständig aus. Das Lot 50 ist dabei vor dem Lötvorgang auch auf nicht metallisierten Bereichen um das Loch 30 herum angeordnet, wodurch sich entsprechende Adhäsionskräfte in Richtung Loch 30 ergeben.

Fig. 4 und 5 zeigen den Zustand nach dem Abkühlen und Aushärten des Lotes 50. Der Zwischenraum ist vom Lot 50 gefüllt, und das Lot 50 hat sich mit der Metallisierung 56 des Loches 30 formschlüssig verbunden. Dies ergibt bereits eine formschlüssige Verbindung zwischen der Leiterplatte 32 und dem Zapfen 28 in einer Ebene der Leiterplatte 32. Zusätzlich ergibt sich durch die Rastnase 52 ein Formschluß in Richtung der Längsachse des Loches 30, d.h. in eine Richtung senkrecht zur Leiterplatte 32. Insgesamt ist somit der Zapfen 28 in allen drei Richtungen des Raumes fest mit der Leiterplatte 32 verbunden bzw. verrastet. Zusätzlich kann diese Verbindung Drehmomentkräfte aufnehmen, ohne daß sich der Zapfen 32 aus dem Loch 30 löst. Hierfür mußte jedoch, wie unmittelbar ersichtlich, keine Einsteckkraft oder Verrastkraft aufgewendet werden. Die Verrastung wurde automatisch im Lötvorgang hergestellt. Zusätzlich ist offensichtlich, daß die Verbindung zwischen Zapfen 28 und Leiterplatte 32 toleranzfrei ist.

## Patentansprüche

1. Bauteil für eine Leiterplatte (32) mit einem Gehäuse (10), an dem wenigstens ein Zapfen (28) zum Eingriff in ein Loch (30) der Leiterplatte (32) ausgebildet ist, wobei der Zapfen (28) wenigstens eine Rastnase (52) aufweist, welche in radialer Richtung bzgl. des Zapfens (28) über dessen Außenumfang hinausragt, wobei die Rastnase (52) am Zapfen (28) derart angeordnet und ausgebildet ist, dass der Außenumfang des Zapfens (28) im Bereich der Rastnase (52) kleiner ist als der Durchmesser des Loches (30) in der Leiterplatte (32),
**dadurch gekennzeichnet,**
**dass** der Umfang des Zapfens (28) in Längsrichtung über den gesamten im Loch (30) der Leiterplatte (32) befindlichen Abschnitt mit wenigstens einer Ausnehmung (54) ausgebildet ist, wobei der geringere Durchmesser des Zapfens (28) im Vergleich zum Loch (30) und die Ausnehmungen (54) derart ausgebildet sind, dass zwischen dem Außenumfang des Zapfens (28) und dem Innenumfang des Loches (30) ein Zwischenraum mit für Lot kapillaren Eigenschaften ausgebildet ist.

2. Bauteil nach Anspruch 1, **dadurch gekennzeichnet, dass** die Rastnase (52) am Zapfen (28) derart angeordnet und ausgebildet ist, dass bei vollständig auf die Leiterplatte (32) aufgesetztem Bauteil die Rastnase (52) innerhalb des Loches (30) in der Leiterplatte (32) angeordnet ist.

3. Bauteil nach wenigstens einem der vorhergehenden Ansprüche, **dadurch gekennzeichnet, dass** das Loch (30) in der Leiterplatte (32) metallisiert ist.

4. Bauteil nach wenigstens einem der vorhergehenden Ansprüche, **dadurch gekennzeichnet, dass** der Zapfen aus Kunststoff hergestellt ist.

## Claims

1. Component for a circuit board (32), having a housing (10) on which at least one peg (28) is configured for engaging in a hole (30) in the circuit board (32), wherein the peg (28) has at least one detent lug (52) which projects in the radial direction relative to the peg (28) beyond the outer periphery of said peg (28), wherein the detent lug (52) on the peg (28) is arranged and configured such that the outer periphery of the peg (28) is smaller in the region of the detent lug (52) than the diameter of the hole (30) in the circuit board (32), **characterised in that** the periphery of the peg (28) in the longitudinal direction is configured over the whole of the section situated in the hole (30) in the circuit board (32) with at least one cutout (54), wherein the smaller diameter of the peg (28) compared with the hole (30) and the cut-outs (54) is configured such that between the outer periphery of the peg (28) and the inner periphery of the hole (30), an intermediate space with capillary properties for solder is formed.

2. Component according to claim 1, **characterised in that** the detent lug (52) on the peg (28) is arranged and configured such that with the component placed fully on the circuit board (32), the detent lug (52) is arranged within the hole (30) in the circuit board (32).

3. Component according to at least one of the preceding claims, **characterised in that** the hole (30) in the circuit board (32) is metallised.

4. Component according to at least one of the preceding claims, **characterised in that** the peg is made from plastics.

## Revendications

1. Composant destiné à une carte à circuits imprimés (32), comprenant un boîtier (10) sur lequel est réalisé au moins un tenon (28) destiné à s'engager dans un trou (30) de la carte à circuits imprimés (32), ledit tenon (28) comportant au moins un ergot d'enclenchement (52) qui fait saillie en direction radiale par rapport au tenon (28) au-delà de sa périphérie extérieure, ledit ergot d'enclenchement (52) étant agencé et réalisé sur le tenon (28) de telle façon que la périphérie extérieure du tenon (28) dans la zone de l'ergot d'enclenchement (52) est plus petite que le diamètre du trou (30) dans la carte à circuits imprimés (32),
**caractérisé en ce que** la périphérie du tenon (28) en direction longitudinale sur la totalité du tronçon qui se trouve dans le trou (30) de la carte à circuit imprimé (32) est réalisée avec au moins un évidement (54), le diamètre réduit du tenon (28) par comparaison au trou (30) et les évidements (54) étant réalisés de telle façon qu'un espace intermédiaire pour de la brasure, avec propriétés capillaires, est réalisé entre la périphérie extérieure du tenon (28) et la périphérie intérieure du trou (30).

2. Composant selon la revendication 1, **caractérisé en ce que** l'ergot d'enclenchement (52) sur le tenon (28) est réalisé et agencé de telle façon que lorsque le composant est totalement posé sur la carte à circuit imprimé (32) l'ergot d'enclenchement (52) est agencé à l'intérieur du trou (30) dans la carte à circuit imprimé (32).

3. Composant selon l'une au moins des revendications précédentes,
**caractérisé en ce que** le trou (30) dans la carte à circuits imprimés (32) est métallisé.

4. Composant selon l'une au moins des revendications précédentes,
**caractérisé en ce que** le tenon est réalisé en matière plastique.
